(19) Europäisches Patentamt
European Patent Office
Office européen des brevets

(11) Publication number: 0 309 190
A2

(12) EUROPEAN PATENT APPLICATION

(21) Application number: 88308686.0

(22) Date of filing: 20.09.88

(51) Int. Cl.4: C08G 73/10 , C08L 79/08 , H05K 3/34 , H01L 23/28

(30) Priority: 22.09.87 US 99876

(43) Date of publication of application:
29.03.89 Bulletin 89/13

(84) Designated Contracting States:
CH DE FR GB IT LI

(71) Applicant: M&T CHEMICALS INC.
One Woodbridge Center
Woodbridge, NJ 07095(US)

(72) Inventor: Powell, David B.
552 Roxbury Road
Belford New Jersey 07718(US)
Inventor: Rose, Bruce H.
6 Locust Crest Court
Poughkeepsie New York 12603(US)

(74) Representative: Paget, Hugh Charles Edward et al
MEWBURN ELLIS & CO. 2/3 Cursitor Street
London EC4A 1BQ(GB)

# (54) Polyimide coating compositions.

(57) Compositions comprising phenolic end-capped polyimides and epoxy resins containing at least two 1,2-epoxy groups per resin molecule are fusible and/or soluble in polar solvents, for use in forming protective passivation coatings on e.g. electrical components. Preferred polyimides are polysiloxane-modified. The coatings are resistant to solvent and solder flux.

EP 0 309 190 A2

# POLYIMIDE COATING COMPOSITIONS

This invention pertains to polyimide protective coating compositions and in particular to polyimide passivation coatings which exhibit excellent solvent and solder flux resistance.

Thermoplastic compositions of siloxane modified polyimides when properly formulated have been demonstrated to possess excellent electrical properties. However, these prior art formulations fail to provide adequate solvent and solder flux resistance required of passivation coatings for printed circuit boards and semiconductor devices.

As a class aromatic polyimides, in general, are not processible. Many are insoluble and are not fusible. In order to coat electrical devices with such compounds, it is necessary to either be able to solubilize or melt these materials. Therefore, most polyimides are handled as polyamic acids (precursors of polyimides) which are soluble. In order to convert the soluble polyamic acids to insoluble polyimides, it is necessary to expose them to high temperatures (e.g., 250° C to 400° C) for several hours.

This treatment converts the amic acid form to the imide by a ring closure accompanied by the elimination of water. The generation of water on the surface of electrical semiconductor devices together with its exposure to high temperatures for lengthy periods of time is undesirable since damage to the electrical component can be a result.

Some polyimides are soluble in N-methyl pyrrolidone or other highly polar solvents that can be difficult to remove or are toxic.

The modification of polyimides with siloxane moieties overcomes this problem by producing a polymer which is soluble in a variety of solvents, such as monoglyme (dimethyl ether of ethylene glycol), diglyme (dimethyl ether of diethylene glycol), toluene, methyl ethyl ketone, N-methyl pyrrolidone and some chlorinated solvents. Solvent removal is easily effected under mild conditions in order to leave the solid siloxane modified polyimide as a passivation coating on the particular electrical substrate. In solving the problem of heating at high temperatures, however, another problem is created. The coating thus deposited is vulnerable to attack by solvents used in their deposition. Unfortunately, these are the same solvents used to remove solder flux following the soldering of various leads to chips, circuit traces and the like.

This flux removal problem was intensified by the wire bonding requirements of integrated circuits and chip-on-board assemblies. The flux used for these wire bonding operations is usually an organic composition. Its removal following the soldering steps is de rigueur because such residues remaining on a circuit board constitute contaminants which can short-circuit or otherwise modify the designed electrical properties of circuit traces, capacitors, resistors and like components of semiconductor and other electronic devices. Flux removal is effected by contacting the device with a saturated atmosphere or vapors of a Freon-methylene chloride mixture while held in a vertical position, followed by immersion in the boiling mixture and finally by exposure to the mixture vapors again. Acceptable passivation compositions must provide films which are insoluble in the flux removal solvents.

The second criterion for passivation compositions arises at an earlier stage in the fabrication of printed circuits or semiconductor devices. The initial step in one commonly used fabrication method involves the screen printing of the passivation coating (or insulating encapsulant) onto a ceramic substrate containing a printed circuit having thick or thin film circuitry. In the case of the former substrate, capacitors and resistors are covered as well as the circuit traces. In the case of the latter substrates the screen printing operation leaves open spaces for chips, resistors, capacitors and other components to be bonded, covering only the circuit traces with an insulating coating. Solder is next placed at points to be electrically connected. The solder flux is present as the core of the cold solder. The resulting assembly is then heated until the solder flows and is cooled. During this stage, solder flux may flow to any point on the substrate and attack the passivation film. The flux is typically an abietic acid rosin mildly activated or non-activated. The desired passivation film coating resists such an attack. If the coating is penetrated by the flux, conducting and/or corrosive residues may be left on the circuit board. Being tacky, these residues also serve as sites for attraction of dust and other contaminants.

Glass coatings have been utilized as passivation coatings because of their insolubility in the Freon-methylene chloride solvents. However, this requires exposure of the assembly to temperatures of 200-400° C in order to cure the glass precursor - a screen printable paste of liquid solvent binder and ceramic particles. At the high temperature, the solvent is burned off and the ceramic particles fused to a glass. Unfortunately at the temperature needed to fuse the ceramic particles, thin film capacitors, resistors and conductive traces may be damaged. This damage can be due to oxidation of the components or to the deleterious effect of high temperature on the resistance value changes. For example, tantalum nitride

oxidizes to tantalum oxide, the latter having a very high resistance. High temperature affects the metallurgy of the metals used for the resistors causing phase changes and consequently resistance value changes. Quite often the electrical values of the resistors are changed under these conditions and have to be corrected by treatment with laser beams to restore their original geometry by trimming. This cuts a line opening in the glass coating exposing the metal resistor to oxidation during use. Further glass coating cannot be used because more resistor value changes would occur.

Room temperature vulcanizable (RTV) silicone rubber have been used in place of the glass coatings. These are not satisfactory for several reasons. First of all, they are not screen printable which necessitates the treatment of each hybrid circuit in a jig to encapsulate separately. Secondly, RTV silicone rubbers have zero resistance to de-fluxing solvents.

Silicone gels are equally deficient as passivation coating compositions.

Epoxy resins are screen printable but their temperature-humidity bias(THB) performance is unsatisfactory. R.G. Mancke discloses a THB test in IEEE Trans. on Components, Hybrids and Manufacturing Technology, Vol. CHMT-4, No. 4, Dec. 1981. This test for semiconductor assemblies measures the current leakage across a gap between two conductor traces of 3 mils over a 1000 hour period at a temperature of 85 °C and a relative humidity of 85%. Chips and other components must show a THB of 10 nanoamps or less to be acceptable.

Epoxy resins also bleed or flow out during cure causing contamination of bond pads. Cured epoxy resins block pads, interfering with or actually preventing the soldering of leads or thermocompression bonding.

Epoxy resins also induce corrosion problems through such curing catalysts as amines, acids, boron trifluoride and the like and halogen containing epihalohydrins used in their synthesis. This necessitates using silicon nitride or other anti-corrosion materials to protect electrical circuits.

In addition to being solvent and solder resistant, passivation or encapsulating compositions should possess the following properties:

(1) room temperature stability or shelf life
(2) screen printability
(3) capable of being packaged as a one component composition
(4) processable at relatively low temperature, i.e., below about 180 °C

In solving the above problems in accordance with the invention, a soluble or fusible, thermally corsslinkable,storage stable coating composition having the properties delineated above is provided by a blend of a phenolic end-capped polyimide and a crosslinking amount of an epoxy resin having at least two 1,2-epoxy groups per molecule.

The phenolic end-capped polyimides of this invention may be prepared by the condensation polymerization of a dianhydride, an organic diamine and p-aminophenol. In stoichiometric amounts they afford a compound having the generic formula:

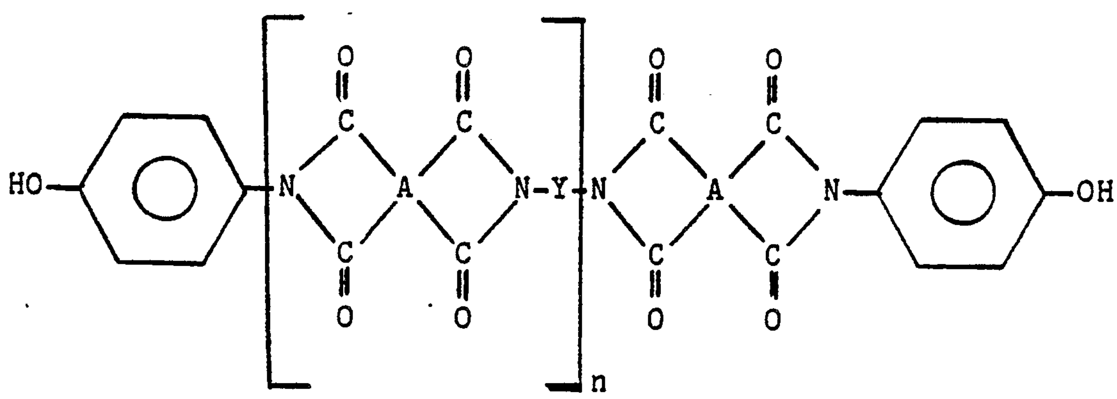

wherein n is an integer between 0 and about 200, preferably 10 to 100;

A is a tetravalent residue of an aromatic dietherdianhydride having the formula:

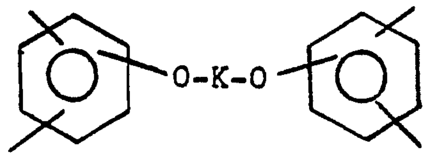

where K is a substituted or unsubstituted group of the formula:

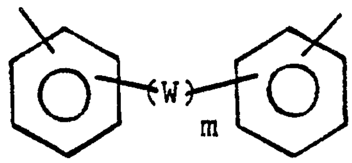

where W is -0-, -S-, $-SO_2$, linear or branched alkylene or alkenylene having 1 to 8 carbons or -(R)C(L)- where R and L can be the same or different lower alkyls having 1 to 8 carbons or aryl groups having 6 to 24 carbon atoms and m is 0 or 1, and Y is one of the following or a mixture thereof:

(a) a divalent residue of an aromatic dietherdiamine having the formula:

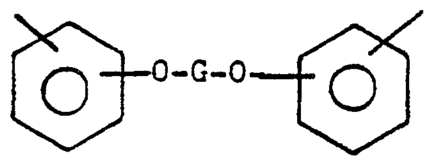

wherein G is substituted or unsubstituted group of the formula:

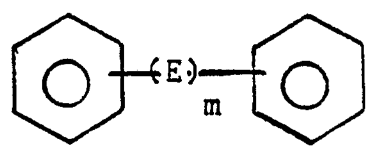

where E is -S-, $-SO_2-$, linear or branched alkenyl or alkenylene or 1 to 8 carbons or -(R)C(L)- where R, L and m are as defined above, and

(b) a divalent residue of a diaminopolysiloxane having the formula:

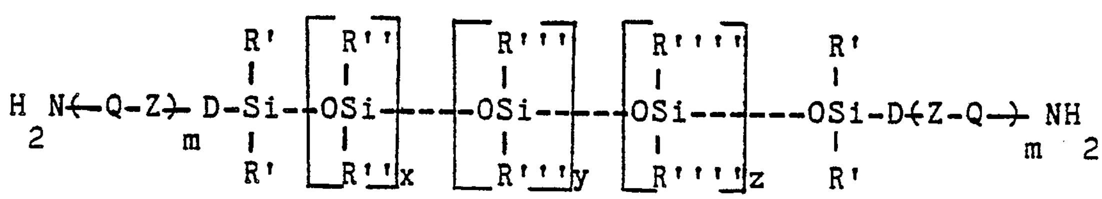

wherein
Q is arylene
Z is a divalent oxygen, sulfide, sulfone, sulfoxide or carboxylic ester or amide group
D is a hydrocarbylene group
R′, R″, R‴ and R⁗ are the same or different alkyls having 1 to 8 carbons, and
x, y and z are integers having values of 0 to 100.

Preferred compounds are those in which W is S and E is either $-SO_2$ or -(methyl)C(methyl)-. It is especially preferred that E is -(methyl)C(methyl)- in siloxane-containing polyimides and E is $-SO_2-$ in non-

siloxane-containing polyimides. The value of m may be 1 accordingly.

The presence of p-aminophenol not only provides the phenolic end-caps but also serves as a chain-stopper. For the siloxane-modified polyimides, the molecular weight range can be about 5000 to about 150,000 with a preferred range being about 10,000 to about 100,000. Non-siloxane containing polyimides with phenol end caps of the same molecular weight can also be used as long as they are soluble in polar solvents. Some polyimides, such as, ULTEM polyimide (General Electric Co.) XU-218 polyimide (Ciba Geigy) and PT 2080 (Upjohn) if modified with phenolic endcaps are suitable. However as mentioned earlier, these materials are only soluble in polar solvents that are difficult to remove and are therefore not as advantageous as the siloxane-containing polyimides. In this molecular weight range the polyimides obtained can be applied as a solution in combination with the epoxy resin, to the appropriate printed circuit or other substrate. For this purpose polar solvents are employed. Suitable polar solvents include N,N-diamethylformamide, N,N-dimethylacetamide, N,N-diethylformamide, N,N-dimethylsulfoxide, N-methyl-2-pyrrolidone, pyridine, dimethylsulfone, phenol, and dimethyltetramethylenesulfone.

Those polyimides that are insoluble but fusible can be applied to substrates as a melt. In this case the polyimide is first heated to a maximum temperature of about 175 °C and then the epoxy resin is blended in. To preclude premature crosslinking or curing of the epoxy, blending must be done rapidly and then the mixture quickly cooled.

The polyimide-epoxy blend can be coated onto the chosen susbstrate, such as a ceramic base of a semiconductor device by extrusion, vacuum forming, transfer molding, spraying, spinning, dip coating, fluidized bed coating and the like.

Polyimides containing siloxane have been prepared using bis-aminoalkyl siloxanes and are disclosed in U.S. 3,740,305 and 4,030,948. While useful as protective coatings for semiconductors and other electronic devices, they exhibit the defect of lack of solvent resistance.

The preparation of aminosiloxanes useful in this invention is known in the prior art. An example is British Pat. No. 1,062,418 and U.S. 4,395,527, incorporated herein by reference, where the reaction of the sodium salt of a phenol or naphthol with a gamma-haloalkyl silane is disclosed. Yields of at least 85% can be achieved when a compound of the formula:

$F'$-Q-Z-M

where $F'$ = H or halogen, M = alkali or alkaline earth metal and Q and Z are as defined above, is reacted with a bis (halohydrocarbyl) disiloxane of formula:

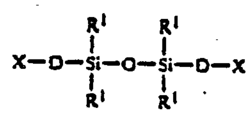

where X is halogen and $R'$ and D are as defined above, at ambient temperature and pressure in the presence of a dipolar aprotic solvent, as for example, dimethyl sulfoxide, N,N-dimethylformamide, tetramethylurea, N-methyl-2-pyrrolidone or hexamethylphosphoramide.

A preferred siloxane-modified polyimide can be synthesized by the condensation polymerization of:

(I) a dianhydride having the generic formula:

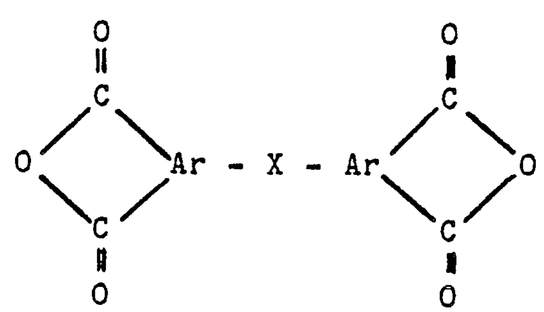

wherein X is at least one of the following: >CO, -O-, -S-, $-SO_2-$ or a valence bond and Ar is an arylene group having 6 to about 10 carbon atoms;

(II) an aromatic etherdiamine having diether linkages and either an arylheteroaryl bridging group in which the hetero atom is sulfur or oxygen or a bisphenol A residue bridging group;

(III) a siloxane modified aromatic ether diamine; and
(IV) an arene substituted with an amino and a hydroxyl group.

The ratio of the anhydride equivalence to the total amine equivalence (the diamine plus the aminophenol) is about 1:1.

Specific, preferred species of the reactants delineated above are:

(I) 4,4'-bis(3,4-dicarboxyphenoxy)diphenyl sulfide dianhydride

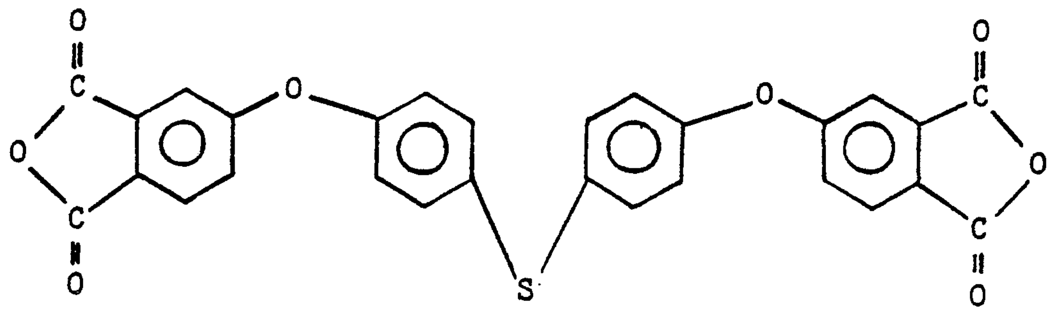

(II) 2,2-bis[4-(p-aminophenoxy)phenyl] propane

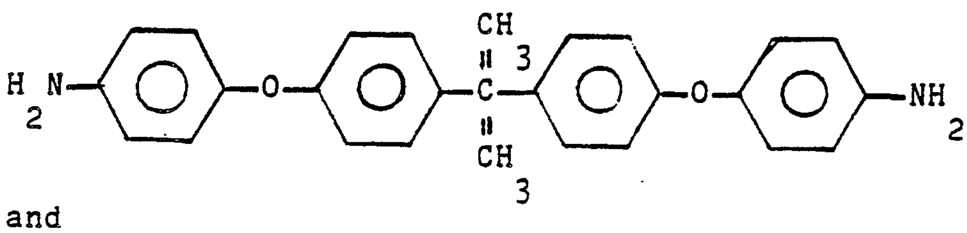

and

2,2-bis[4-(p-aminophenoxy)phenyl] sulfone

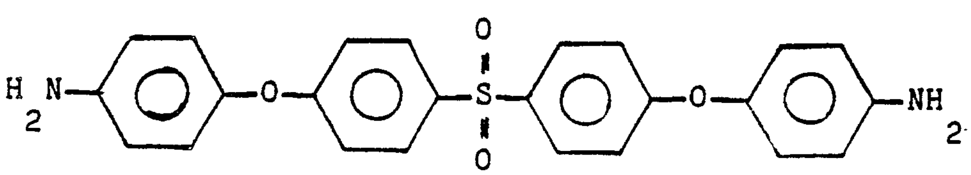

(III) bis(m-aminophenoxybutyl)hexadecamethyloctasiloxane

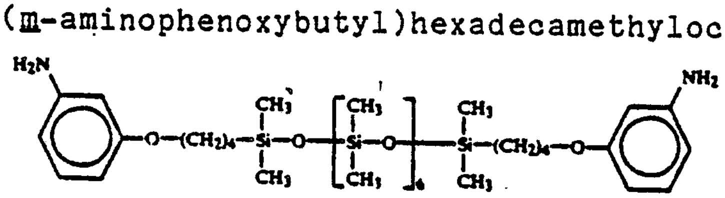

(IV) p-aminophenol 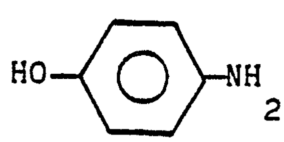

A mixture of aromatic diamines can be used to synthesize the polyimides of this invention. For example, it is preferred to use about 25-50 mole % of 2,2-bis[4-(p-aminophenoxy) phenyl]propane and 50-75 mole % of a diaminopolysiloxane. It is even more preferred to use about 35 mole % of the former and about 65 mole % of the latter. A preferred diaminopolysiloxane is bis(m-aminophenoxybutyl)-hexadecamethyloctasiloxane.

While the exact molecular architecture of these macromolecules has not been ascertained, it is believed that the radical residua of structures II and III can be randomly distributed with I in the backbone structure or they can be present as groups or blocks of I or II as well as groups of I and III. These moieties are the residues left after imide linkages are formed from the reaction of the anhydride and amino groups of structures I, II and III respectively. The terminal or end groups are

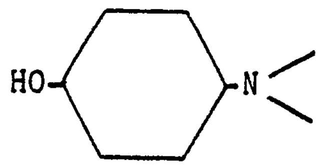

groups where the N forms part of an imide linkage arising out of the reaction of p-aminophenol with a chain terminating anhydride group.

Typical of the epoxy resins of this invention are the polyglycidyl ethers of polyhydric phenols, and other epoxy resins having a minimum of two and suitably three or four and more epoxy groups, ie.,

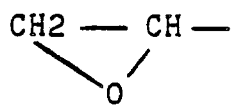

per molecule and can be saturated, unsaturated aliphatic, cycloaliphatic, aromatic, or heterocyclic and can be substituted with, for example, hydroxyl groups, halogen atoms, ether radicals and the like. Among the suitable di-and polynuclear phenols suitable for preparation of polyglycidyl ethers are the bisphenols described by Bender et al. in U.S. Patent 2,506,486 and polyphenols such as the novolac condensation product of a phenol and a saturated or unsaturated aldehyde containing on an average of from 3 to 20 or more phenylol groups per molecule (cf. book by T.S. Carswell entitled "Phenoplasts," published in 1947 by Interscience Publishers of New York). Examples of suitable polyphenols derived from a phenol and an unsaturated aldehyde such as acrolein, are the triphenylol, pentaphenylols and heptaphenylols described in U.S. Patent No. 2,801,989, and U.S. Patent No. 2,885,385 both by A. G. Farnham.

Generally, these polyglycidyl ethers of polyhydric phenols are prepared by the reaction of an epihalohydrin with a polyhydric phenol under basic conditions. The polyhydric phenol can be mononuclear such as resorcinol, catechol, methylresorcinol or hydroquinone, or may be di- or polynuclear.

The polyhydric polynuclear phenols can consist of two or more phenols connected by such groups as alkylidene, alkylene, ether, ketone or sulfone. The connecting groups are further exemplified by the following compounds: bis(p -hydroxyphenyl) ether, bis(p-hydroxyphenyl) ketone, bis(phydroxyphenyl)-methane, bis(p-hydroxyphenyl)dimethyl methane, bis(p-hydroxyphenyl)benzophenone, 1,5-dihydroxynaphthalene, bis(p-hydroxyphenyl) sulfone or a trisphenol or a tetraphenol.

Preferred as the epihalohydrin for reaction with the above polyhydric phenols are epichlorohydrin, glycerol dichlorohydrin, 3-chloro-1,2-epoxy butane, 3-bromo-1,2-epoxy hexane, and 3-chloro-1,2-epoxy octane.

Other polyepoxides such as bis(2,3-epoxycyclopentyl) ether, 3,4-epoxy-6-methylcyclohexylmethyl, 3,4-epoxy-6-methylcyclohexanecarboxylate, vinyl cyclohexene dioxide and dicyclopentadiene dioxide can also be used.

Other epoxy resins that can be employed herein are the epoxylated novolac resins. Novolac resins are prepared by the condensation of phenol with an aldehyde, or more generally, by the reaction of a phenolic compound, having two or three reactive aromatic ring hydrogen positions, with an aldehyde or aldehyde-liberating compound capable of undergoing phenol-aldehyde condensation.

Illustrative of phenolic compounds are cresol, xylenol, ethylphenol, butylphenol, isopropylmethoxyphenol, chlorophenol, resorcinol, hydroquinone, naphthol, 2,2-bis(p-hydroxyphenol) propane, and the like.

Illustrative of aldehydes are formaldehyde, acetaldehyde, acrolein, crotonaldehyde, furfural, and the like. Illustrative of aldehyde-liberating compounds are for, example, paraformaldehyde, formalin and 1,3-5-trioxane. Ketones such as acetone are also capable of condensing with the phenolic compounds, as are methylene engendering agents such as hexamethylenetetramine.

The condensation reaction is conducted in the presence of an acidic catalyst using less than six moles of aldehyde per seven moles of phenol. The novolac resins thus produced are permanently fusible and soluble. When the condensation reaction is completed, if desired, the water and other volatile materials can be removed by distillation and the catalyst neutralized.

In a typical synthesis, novolacs are prepared by heating one mole of phenol with 0.8 mole of an aldehyde under acidic conditions. The temperature at which the reaction is conducted is generally from about 25 °C to about 175 °C.

The epoxylated novolac resins used in this invention can be prepared by the epoxidation of the novolac by methods well known in the art, as for example, by reaction with an epihalohydrin as described in Epoxy Resins by H. Lee and K. Neville, McGraw Hill Book Co., page 195, N.Y.C.

Still another class of useful epoxy resins is derived from the reaction of an epihalohydrin with compounds containing reactive hydrogen atoms. Representative of this class are the glycidylamines, such as, N,N,N′,N′-tetraglycidyl-4,4′-methylenebisbenzamine. Other epoxy resins known to those skilled in the art can also be used if desired.

Although the amount of epoxy resin used in the claimed compositions is not critical, the amount should be sufficient to crosslink and harden the phenolic end-capped polyimide. It is preferred to use about 1 to about 25 parts per hundred of the phenolic end-capped polyimide resin (phr). A more preferred range is about 1 to about 10 phr.

In using these crosslinkable phenolic end-capped polyimide resins for depositing solvent and flux resistant films on semiconductor devices in particular and substrates in general, it is preferred to first deposit a dispersion of the resin in a solvent or diluent on the surface to be coated to afford a coated substrate which is then heated at about 100 °C to about 225 °C until a film forms. Preferred temperature ranges are about 150 °C to about 200 °C. Heating time is not critical, although the higher the curing temperature the faster the cure or film formation will be. The deposition can be effected by screen printing where the nature of the substrate requires it.

No catalysts are required for the crosslinking operation. This is fortuitous since it permits the mixing of polyimide and epoxy resin into a single package composition. Heating alone suffices to induce the crosslinking operation. Catalysts can be used however, if desired, although this necessitates the use of two package systems unless latent curing agents are employed. When used, suitable catalysts include organic acids, organic acid anhydrides, tertiary amines, and the like.

Embodiments of the invention are described in the examples that follow. All parts and percentages are by weight unless otherwise specified.

## EXAMPLE 1

### Preparation of Phenol End-capped Polyimide

A 75 gallon reaction vessel equipped with a stirrer, temperature recording and controlling means and a reflux column fitted with a moisture trap was charged with 7631 grams of 4,4′-bis(3,4-dicarboxyphenoxy)-diphenyl sulfide dianhydride (structure I), 6047 grams of bis[4-(p-aminophoxy)phenyl] sulfone structure(II), 244 grams of p-aminophenol, 37.5 grams of p-toluenesulfonic acid, and 262 lbs of monochlorobenzene as a solvent.The mix was heated at reflux temperature for about 6 hours. During this period about 40 lbs of monochlorobenzene was removed as an azeotrope with water in a phase splitter used as the moisture trap. The stripped monochlorobenzene was replaced with dry solvent followed by the addition of 102 lbs of N-methyl-2-pyrrolidone. The reaction product was precipitated in methanol,filtered and the phenol end-capped polyimide dried overnight @75 °C in a vacuum oven. The dried polyimide was dissolved in N-methyl-2-pyrrolidone to form an 18% solids solution. This polyimide has units of the structure:

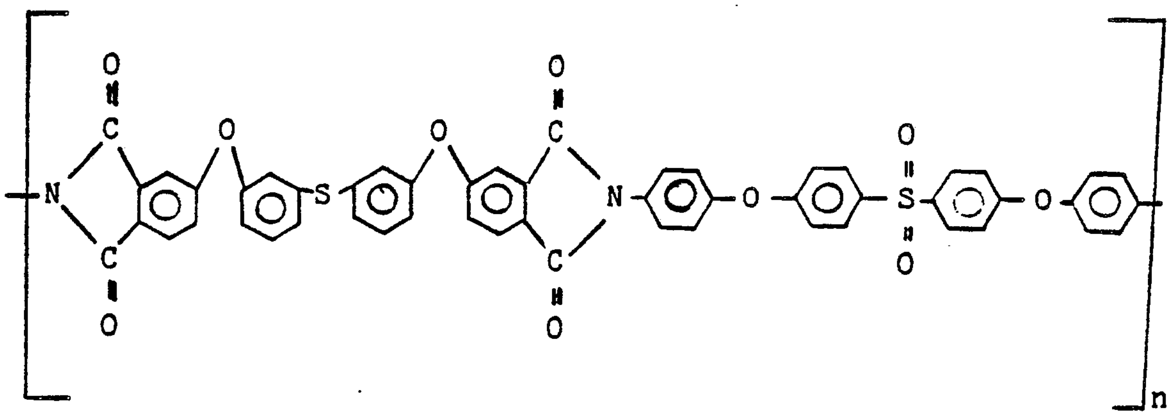

where n′ is an integer having values of 1 to about 10. End caps are afforded by the condensation of p-aminophenol with terminal anhydride groups producing p-hydroxyphenylimide groups.

Films of this polyimide were cast on glass plates, 6"x 6"x 0.25" by effecting 10 mil wet drawdowns with a doctor blade of 18% solids solution in N-methyl-2-pyrrolidone. The resultant films were dried overnight at 125° C. Solvent resistance of these films was evaluated by placing one drop of N-methyl-2-pyrrolidone on three different areas of each plate and covering the drops with a watch glass to prevent solvent evaporation. These samples were checked periodically for solvent attack by rubbing the solvent treated areas with a paper towel. After 10 minutes contact time with the solvent, complete dissolution of the polyimide took place evincing zero solvent resistance to N-methyl-2-pyrrolidone.

The solvent resistance test described above was repeated with the same polyimide (18% solids solution) with the exception that 0.018 grams(1.44 phr) of Quatrex 2010 (an epoxy novolac resin having an epoxide equivalent weight of 178 and a viscosity of 35,000 cs at 25° C available from Dow Chemical U.S.A. at Midland, Michigan) was added. Films were cast and dried as above. The dried films when evaluated for solvent resistance as above were still intact after 3 hours although they developed a dull appearance. This was interpreted as evidence of solvent resistance.

## EXAMPLE 2

### Preparation of Siloxane-Containing Phenol End-capped Polyimide

To a 3 liter round-bottom flask equipped with a stirrer, thermometer, nitrogen inlet tube, reflux condenser, two distillation columns, modified Dean-Stark moisture trap and heating mantle was charged the following:

1017.6g monochlorobenzene
11.55g(0.28 moles) 2,2-bis[4-(p-aminophenoxy)phenyl]propane plus 50g monochlorobenzene
46.87g(0.053 moles) bis(m-aminophenoxybutyl)hexadecamethyloctasiloxane plus 100g monochlorobenzene
0.267g p-aminophenol plus 10 g monochlorobenzene

This mixture was stirred until solution was effected. Then 11.55 g (or 41.62g) 4,4′-bis(3,4-dicarboxyphenoxy)diphenyl sulfide dianhydride plus 100g monochlorobenzene and 0.2g p-toluenesulfonic acid in 10g monochlorobenzene were added.

This reaction mixture was heated at reflux for 1-2 hours during which time 214.6g of distillate were topped off. Refluxing was continued for 12 hours. The mixture was allowed to cool to room temperature with stirring. Then 308g of N-methylpyrrolidone were added with stirring. The resultant polymer, a siloxane containing, phenol end-capped polyimide was precipitated by adding 500 ml of the reaction mixture into 3500 ml of rapidly stirred methanol at room temperature. The precipitated polyimide was allowed to settle and the supernatant liquid siphoned off. The polyimide was suspended again in 2500 ml of fresh methanol and stirred vigorously for 15-20 minutes. The polyimide was again allowed to settle and the supernatant liquid siphoned off. The polyimide was filtered through coarse filter paper using a Buchner funnel, washed with 1000 ml of methanol and dried with suction for about 10 minutes. The polyimide was air dried

overnight and then oven dried at 70 °C for 16-24 hours.

Films of the condensation polymer obtained above were cast and tested as in Example 1. They showed little solvent resistance to N-methyl-2-pyrrolidone, dissolving in 10 minutes.

This same condensation polymer with about 8 phr of Quatrex 2010 added showed solvent resistance for 18 hours in the same test. Again, there was a dulling of the film surface.

## EXAMPLE 3

### Polysiloxane-Containing, End-capped Polyimide Paste

A paste of the polyimide prepared in Example 2 (35% wt/vol) in diglyme (dimethyl ether of diethylene glycol) was cast on glass plates and dried to a film 1 mil thick for 3 hours at 180 °C or 200 °C respectively. Additional paste samples containing about 0.4%, 1.0%, 2.0% and 4.0% of Quatrex 2010 were also cast to 1 mil films as above.

A typical commercial paste contains minor amounts of a silica filler such as Cab-O-Sil PTG and a surfactant, such as Dow Corning DB-100 paint additive silicone surfactant.

Solvent resistance of the cast films was first measured by placing drops of Freon TMC (a mixture of Freon 112 and methylene chloride, 1:1) on the film samples as in Example 1.

A more rigorous solvent resistance test is described below.

Two layers of Scotch tape were placed on each side of 0.5"x1.5" ceramic coupons flush with the edge. The tape strips were about 3 mils thick. A drop of the paste described above was placed on the exposed-(untaped) section of the ceramic coupons and drawn down to a thickness of 1 mil. The tape was removed after razor edging the center sections and the coupons dried first for one hour at 120 °C and then for 3 hours at 180 °C. The coupons were now exposed to boiling Freon TMC vapors for 8 minutes, then immersed in boiling Freon TMC for 10 minutes and finally exposed to boiling Freon TMC vapors again for 8 minutes. Those specimens which were classed "solvent resistant" showed no deterioration from this treatment.

The flux resistance test is the same as the solvent resistance test up to the point of exposure to the Freon TMC. At this stage an abietic acid, non-activated flux in isopropanol (available from the Alpha Metals Co. of Jersey City, N.J. as Alpha 4308) was swabbed over the dried paste. The coupons were then run over a Brown Belt Solder Reflow Unit conveyorized track passing through two hot zones, one at 180 °C and a second at 260 °C. This treatment causes the flux to flow simulating flux reflow in a soldering operation. At this point the coupons were treated as in the solvent resistance test above with successive exposures to Freon TMC. Failure is indicated when the film is dissolved off the coupons by the Freon TMC.

The evaluation data presented in Table 1 show that samples containing no epoxy resin failed the solvent and flux resistance tests. Samples containing 0.4% epoxy resin were solvent resistant but not flux resistant.

Samples containing 1 to 4% epoxy resin were both solvent and flux resistant after drying for 3 hours at 180 ° or 200 °C.

TABLE 1

| % Epoxy/100g Polyimide Paste | Coating Dried @180 °C Resistant to | | Coatings Dried @200 °C Resistant to | |
|---|---|---|---|---|
| | Freon TMC | Flux | Freon TMC | Flux |
| None | No | No | No | No |
| 0.4 | Yes | No | Yes | No |
| 1.0 | Yes | Yes(a) | Yes | Yes(b) |
| 2.0 | Yes | Yes(b) | Yes | Yes(c) |
| 4.0 | Yes | Yes(c) | Yes | Yes(c) |

(a) some discoloration
(b) slight discoloration
(c) very slight discoloration

## Example 4

### Preparation of 2,2-bis[4-(p-aminophenoxy)phenyl]propane

Another preferred diamine used in the synthesis of polyimides of this invention is 2,2-bis[4-(p-aminophenoxy)phenyl] propane. It can be prepared as follows. Into a 2 liter, 3-necked flask equipped with a stirrer, nitrogen inlet tube, reflux condenser, heating mantle and Dean-Stark moisture trap is charged under an atmosphere of nitrogen a mixture of:

Bisphenol A [2,2-bis(p-hydroxyphenyl)propane] 221.4 g
5% Aqueous NaOH Solution 155.2 g
Toluene 500 ml
Dimethyl sulfoxide 500 ml

This mixture is heated to reflux temperature and water removed as an azeotrope in the moisture trap. After about 6 hours the sodium salt of Bisphenol A begins to crystallize out of solution.

The reaction temperature is lowered to about 70 °C and 306g of p-chloronitrobenzene added to the flask maintaining the temperature at 70 °C overnight. The reaction mixture is cooled, filtered and stripped free of toluene under vacuum. A yellow solid, 2,2-bis[4-(p-nitrophenoxy)phenyl]propane, precipitates and is isolated by filtration. Fifty grams of the precipitate are dissolved in dimethylformamide and five grams of Raney nickel added. This mixture is hydrogenated in a Paar hydrogenation bomb at 50 psig and 80 °C. When hydrogen absorption ceases, the bomb contents are filtered and poured slowly into an excess of water. The product, 2,2-bis[4-(p-aminophenoxy)phenyl]propane, can be crystallized from toluene-hexane.

Other organic diamines that can be used in preparing polyimides for this invention include:

m-phenylenediamine
p-phenylenediamine
4,4′-diaminodiphenylpropane
4,4′-diaminodiphenylmethane
benzidine
4,4′-diaminodiphenylsulfide
4,4′-diaminodiphenylsulfone
4,4′-diaminodophenyl ether
1,5-diaminonaphthalene
m-xylylenediamine
p-xylylenediamine, and mixtures thereof.

Exemplary siloxane-containing diamines which lend themselves to the preparation of polyimides useful in this invention include:

bis(gamma-aminopropyl)tetramethyldisiloxane

bis(p-aminophenylthiobutyl)tetramethyldisiloxane
bis(m-aminophenoxypropyl)tetramethyldisiloxane
bis(p-aminophenoxybutyl)tetramethyldisiloxane
bis(p-aminophenylsulfoxobutyl)tetramethyldisiloxane
bis(p-aminophenylcarbamoylpropyl)tetramethyldisiloxane, and mixtures thereof.

## Example 5

### Preparation of Bis(p-aminophenylthiobutyl)tetramethyldisiloxane

A representative synthesis of this disiloxane is presented below.

A glass reactor is charged with 43.28 parts of a 50% aqueous NaOH solution, 112 parts dimethylsulfoxide(DMSO), 120 parts toluene and 68.75 parts of p-aminothiophenol. The mixture is heated to boiling under an nitrogen atmosphere with rapid agitation. Water is removed by azeotropic distillation. The temperature of the reaction mass increases from 110° C to about 122° C while stirring for about 7-8 hours. The reaction is cooled to about 80° C and 86.6 parts of bis(chlorobutyl)tetramethyldisiloxane is added dropwise to the reaction mixture. The reaction mixture is heated for an additional 16 hours.

The course of the reaction is followed by examining samples with vapor phase chromatography. The mixture is filtered and the solvents removed by vacuum distillation. The product is recovered as a distillation cut at 310° C to 315° C at 0.1-0.5 mm. The chemical structure is confirmed by infrared spectroscopy.

Although the invention has been described with a certain amount of particularity, it is understood that the present disclosure has been made only by way of example and that numerous changes can be made without departing from the spirit and the scope of the invention.

## Claims

1. A coating composition comprising a blend of a phenoxy end-capped polyimide and a crosslinking amount of an epoxy resin having at least two 1,2-epoxy groups per resin molecule.

2. A coating composition according to claim 1 wherein the polyimide is present as a solution in a polar solvent, or as a melt.

3. A coating composition according to claim 1 or claim 2 wherein the polyimide has the formula:

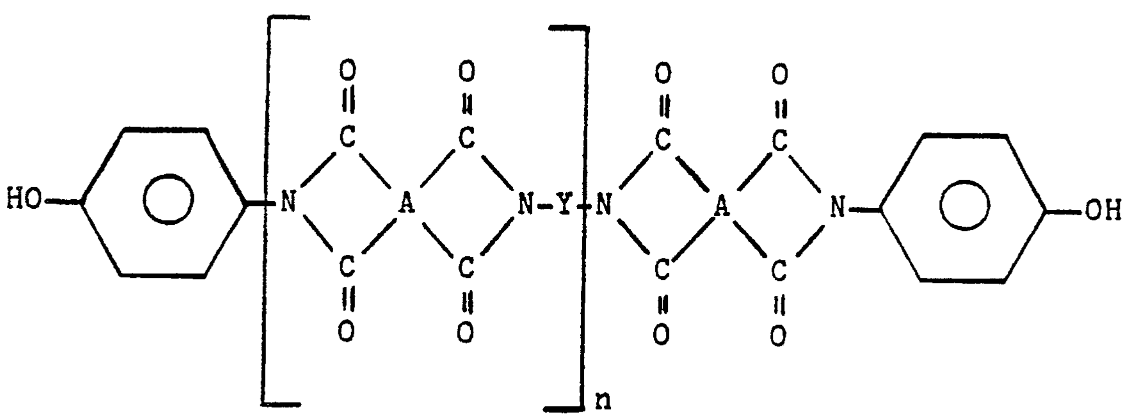

wherein n is an integer having values of 0 to about 200,
A is a tetravalent residue of an aromatic dietherdianhydride having the formula:

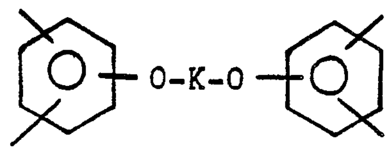

where K is a substituted or unsubstituted group of the formula:

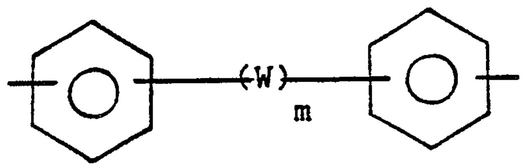

where W is -O-, -S-, $-SO_2-$, linear or branched alkylene or alkenylene having 1 to 8 carbons or -(R)C(L)- where R and L are the same or different lower alkyls having 1 to 8 carbons or lower alkenyl or substituted or unsubstituted aryl groups of 6 to 24 carbons amd m is 0 or 1 and Y is one of the following or a mixture thereof:

(a) a divalent residue of an aromatic dietherdiamine having the formula:

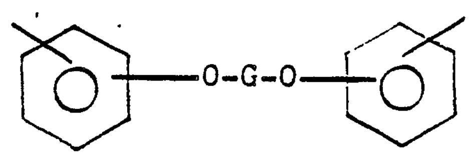

wherein G is a substituted or unsubstituted group of the formula:

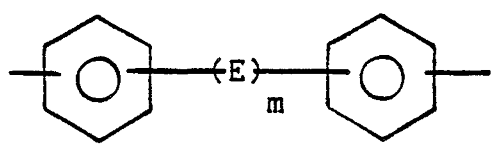

where E is -S-, $-SO_2-$, linear or branched alkenyl or alkenylene of 1 to 8 carbons or -(R)C(L)- where R, L and m are as defined above, and

(b) a divalent residue of a diaminopolysiloxane having the formula:

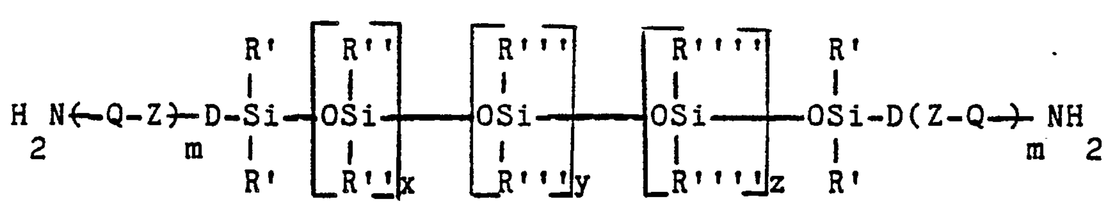

wherein
Q is arylene
Z is a divalent oxygen, sulfide, sulfone, sulfoxide or carboxylic ester or amide group
D is a hydrocarbylene group
$R'$, $R''$, $R'''$ and $R''''$ are the same or different alkyls containing 1 to 9 carbons, and
x, y and z are integers having values of 0 to 100.

4. A coating composition according to claim 3 wherein Y is a mixture of (a) and (b) and the mole ratio of (a) to (b) is between about 10:90 and about 90:10.

5. A coating composition according to claim 3 wherein the aromatic dietherdianhydride is bis[p-(3,4-dicarboxyphenoxy)phenyl] sulfide dianhydride, and/or the aromatic diamine is 4,4′-bis(p-aminophenoxy)-diphenyl sulfone.

6. A coating composition according to claim 3 wherein the aromatic diamine is a mixture of about 25-50 mole % of 2,2-bis[4-(p-aminophenoxy)phenyl]propane and about 50-75 mole % of a diaminopolysiloxane.

7. A coating composition according to claim 6 wherein the diaminopolysiloxane has the structure

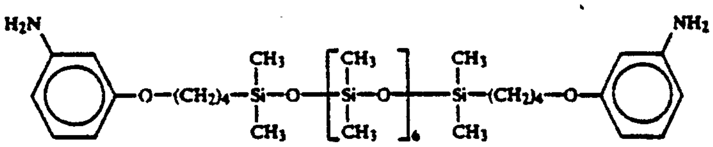

8. A coating composition according to any one of the preceding claims wherein the crosslinking amount of epoxy resin is from about 1 to about 25 parts per hundred parts by weight of polyimide, and preferably from about 1 to about 10 parts per hundred parts by weight of polyimide.

9. A coating composition according to any one of the preceding claims wherein the epoxy resin is a glycidylamine, an epoxylated novolac resin or a polyglycidylether of a polyhydric phenol.

10. A process comprising manufacture of a coating composition according to any one of the preceding claims.